(19) Europäisches Patentamt
European Patent Office
Office européen des brevets

(11) Publication number: 0 103 304
B1

(12) # EUROPEAN PATENT SPECIFICATION

(45) Date of publication of patent specification: 27.04.88

(51) Int. Cl.$^4$: C 04 B 35/46, H 01 L 41/18

(21) Application number: 83109069.1

(22) Date of filing: 14.09.83

(54) **Piezoelectric oxide material.**

(30) Priority: 14.09.82 JP 158896/82

(43) Date of publication of application: 21.03.84 Bulletin 84/12

(45) Publication of the grant of the patent: 27.04.88 Bulletin 88/17

(84) Designated Contracting States: DE FR GB NL

(56) References cited:
EP-A-0 034 342
JP-A-81 115 582
US-A-3 424 686

(73) Proprietor: KABUSHIKI KAISHA TOSHIBA
72, Horikawa-cho Saiwai-ku
Kawasaki-shi Kanagawa-ken 210 (JP)

(72) Inventor: Yamashita, Youhachi
Tokyo Shibaura Denki K.K. 72, Horikawa-cho
Saiwai-ku Kawasaki-shi Kanagawa-ken (JP)
Inventor: Yoshida, Seiichi
Tokyo Shibaura Denki K.K. 72, Horikawa-cho
Saiwai-ku Kawasaki-shi Kanagawa-ken (JP)
Inventor: Takahashi, Takashi
Tokyo Shibaura Denki K.K. 72, Horikawa-cho
Saiwai-ku Kawasaki-shi Kanagawa-ken (JP)
Inventor: Suzuki, Syuzi
Tokyo Shibaura Denki K.K. 72, Horikawa-cho
Saiwai-ku Kawasaki-shi Kanagawa-ken (JP)

(74) Representative: Hansen, Bernd, Dr.rer.nat. et al
Hoffmann, Eitle & Partner Patentanwälte
Arabellastrasse 4
D-8000 München 81 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 103 304 B1

**Description**

This invention relates to the use of a piezoelectric oxide material for an ultrasonic probe for medical use including a probe of a medical ultrasonic diagnosis system and a probe of an ultrasonic metal flaw detecting apparatus, and a vibrator of a hydrophone or a sonar.

The ultrasonic conversion elements of these systems and apparatus use longitudinal-mode waves ($K_{33}$ vibrations) of 0.5 to 10 MHz as vibration modes thereof. Since the efficiency of electroacoustics that converts electric energy to ultrasonic vibrations and ultrasonic vibrations to electric energy is proportional to the square of the electromechanical coupling factor $K_{33}$, better sensitivity is available with a material having a greater $K_{33}$ value. Since, however, it becomes more difficult to suppress occurrence of spurious vibrations due to the effect of transverse waves when the transverse-mode wave has a larger $K_{31}$ value, a material having a large $K_{33}$ value and small $K_{31}$ value is therefore desired.

Ultrasonic diagnosis systems, which are used most extensively these days, are of the pulse reflection system. In the pulse reflection system, it is necessary to transmit and receive short pulses if one wants to enhance the resolution. Accordingly, it is desired to lower the mechanical quality factor (Qm) of the probe material so that the breaking time of each pulse can be shortened.

On the other hand, there is a recent trend to make the pulse drive circuit (i.e., pulser) of each ultrasonic diagnosis system operable over a wide band. Accordingly, it is now under way to lower the impedance of such a pulse drive circuit. Since the impedance matching has to be achieved between the material of a probe and its corresponding pulser circuit, there is an outstanding demand for the development of a piezoelectric material having a high dielectric constant of about 300 to 2000.

As probe materials of the above sort, there have conventionally been used quartz, $LiNbO_3$, and composite ternary system ceramics such as barium titanate type ceramics and lead zirconium titanate type ceramics. Quartz and $LiNbO_3$ are however unsuitable as probe materials of the above sort, because they have small electromechanical coupling factors ($K_{33}$) and large Qm values.

On the other hand, composite ternary system ceramics such as barium titanate type ceramics and PZT-type ceramics are accompanied by some limitations in machining them into vibrators in order to minimize the transverse effect of $K_{31}$ since their $K_{31}$ values, which are of vibration modes giving the transverse effect, are as high as 20 to 40% and the $K_{33}/K_{31}$ ratios remain as low as 2 to 3, although their dielectric constants are high and their electromechanical coupling factors $K_{33}$ are as high as 40 to 65%. On the other hand, there have also been known materials having $K_{33}/K_{31}$ ratios as great as 5 to 10, such as $PbTiO_3$, $PbNb_2O_6$, etc. However, the dielectric constants of these materials are as low as 150 to 300, whereby making them difficult to meet the recent trend toward use of low impedance pulser circuits for ultrasonic diagnosis systems. Besides, $PbTiO_3$ type materials and $PbNb_2O_6$ type materials have to be subjected to their poling processing at elevated temperatures and under high electric fields. These materials are thus difficult to provide large size vibrators due to breakdown which takes place during such poling processing.

JP—A—56 115 582 (10.9.81) discloses a piezoelectric material comprising a basic composition, having the general formula

$$(Pb_{1-a}Ca_a)[(Me_{1/3}Nb_{2/3})_xTi_{1-x}]O_3,$$

wherein Me is either one of Zn and Mg, x=0.01 to 0.10 and a=0.05 to 0.35. The piezoelectric oxide material disclosed in this prior art is designated for the use in a surface wave filter or a large sized vibrator, and the dielectric constant is required to be 300 or less. But with an dielectric constant of 300 or lower the electrical impedance matching with a probe at the measurement cannot be readily performed.

The present invention comprises the use of a piezoelectric oxide material comprising a composition represented by the general formula:

$$(Pb_{1-a}Ca_a)[(Zn_{1/3}Nb_{2/3})_xTi_{1-x}]O_3$$

wherein $0.10<x\leqq0.30$, and $0.10<a\leqq0.35$, and having the mechanical quality factor (Qm) of 200 or smaller, the dielectric constant of 300 or greater, the $K_{33}$ value of 50% or greater and the $K_{33}/K_{31}$ ratio of 5 or greater for an ultrasonic probe for medical use including a probe of a medical ultrasonic diagnosis system and a probe of an ultrasonic metal flaw detecting apparatus, and a vibrator of a hydrophone or a sonar.

This invention will be described below in detail with reference to the accompanying drawings.

In the basic composition of $(Pb_{1-a}Ca_a)[(Zn_{1/3}Nb_{2/3})_xTi_{1-x}]O_3$ the value *a* is limited to $0.10<a\leqq0.35$, preferably $0.20\leqq a\leqq0.30$, because the coupling factor $K_{33}$ and dielectric constant become 50% or smaller and 300 or less respectively if $a\leqq0.10$, while, if $a>0.35$, the Curie point becomes 150°C or lower and it thus becomes more likely that the material would be depolarized during the cutting step upon machining the material into a probe after its poling or in the course of the soldering step of leads.

The value x is limited to $0.10<x\leqq0.30$, preferably $0.15\leqq x\leqq0.25$, because, when $x\leqq0.10$, the ceramic has not only a small coupling factor $K_{33}$ of 50% or smaller but also a low dielectric constant of 300 or lower and the impedance matching with the pulse drive circuit will become harder if the ceramic is employed to form

a probe and, when x>0.30, its Curie temperature becomes 150°C or lower and its $K_{31}$ value increases, thereby making the ceramic not different so much from PZT ceramics.

The piezoelectric oxide material used according to this invention can generally be produced with ease by the powder metallurgical process. For example, such raw material oxides as PbO, $TiO_2$, $CaCO_3$, ZnO and $Nb_2O_3$ are proportioned and then mixed well in a ball mill or the like. Here, the raw materials may be such compounds that can be converted to their corresponding oxides by their heating or the like. For example, hydroxides, carbonates or oxalates may also be used.

Thereafter, the thus-proportioned mix is calcined at temperatures of about 600 to 900°C, followed by its grinding in a ball mill or the like so as to provide a fine powder mix. Then, a binder such as water or polyvinyl alcohol is added at a prescribed proportion to the fine powder mix and then dry-formed at a pressure of 50 to 200 MPa (0.5 to 2 tons/$cm^2$) or so. The thus-formed compact is thereafter sintered at temperatures in the range of 1100 to 1200°C or so. Since there is a danger that a part of PbO, one of the batch constituents, may evaporate during the sintering, it is preferred to conduct the sintering of the compact in a closed furnace. It is generally sufficient for the sintering of the compact to hold the compact for about 0.5 to 3 hours at the maximum temperature.

Accordingly, the present invention can bring about such effects as will be described below. First of all, conventional PZT materials and ternary system materials involved some problems due to spurious vibrations resulted from transverse vibrations ($K_{31}$, Kp) when applied for fabrication of vibrators making use of longitudinal vibrations ($K_{33}$, Kt), because the ratios of their longitudinal coupling factors $K_{33}$ to transverse coupling factors $K_{31}$ ranged from 2 to 3. However, the material which is used according to this invention has small spurious vibrations and is thus advantageous from the practical viewpoint, since its longitudinal coupling factor $K_{33}$ takes a value as large as 50% or greater while its transverse coupling factor $K_{31}$ is a small value of 10% or lower. Secondly, the material of this invention has a relatively large dielectric constant which ranges from 300 to 1200, it facilitates the matching in impedance with the pulse drive circuit of an ultrasonic diagnosis system. Thirdly, the material of this invention has a small Qm value and hence permits fast attenuation for pulses, in other words, shortens the breaking times of pulses. It thus permits transmission and reception of short pulses, whereby it improves the resolution of an ultrasonic diagnosis system. Fourthly, the material of this invention permits to carry out its poling processing at 100°C and 30 to 50 KV/cm. Accordingly, large substrates may be fabricated with ease.

Examples of this invention will next be described.

Examples

A disk of 20 mm in diameter and 0.5 mm in thickness and a square rod of 2 mm wide, 2 mm high and 6 mm long were cut out from each sample, see Table 1, which had undergone its sintering. Silver paste was baked at 700°C on both surfaces of each of the disk and rod. They were thereafter subjected to a poling treatment by immersing them in silicone oil of 50 to 100°C and applying a DC electric field of 20 to 40 KV/cm. Their piezoelectric characteristics were measured by the IRE standard circuit method. These measurement results are given in Table 1, along with the composition of samples.

TABLE 1

| Sample | $(Pb_{1-a}Ca_a)[(Me_{1/3}Nb_{2/3})_xTi_{1-x}]O_3$ | | | Dielectric constant | Coupling factor $K_{33}$(%) | Coupling factor $K_{31}$(%) | $K_{33}/K_{31}$ | Qm | Curie point Tc(°C) |
|---|---|---|---|---|---|---|---|---|---|
| | a mol(%) | Me | x mol(%) | | | | | | |
| Example 1 | 11 | Zn | 15 | 306 | 50.1 | 5.2 | 9.63 | 133 | 360 |
| 2 | 15 | " | 15 | 343 | 50.8 | 5.7 | 8.91 | 139 | 339 |
| 3 | 20 | " | 15 | 350 | 51.4 | 6.3 | 8.16 | 140 | 311 |
| 4 | 25 | Zn | 15 | 367 | 51.7 | 6.6 | 7.83 | 159 | 284 |
| 5 | 30 | " | 15 | 411 | 52.3 | 7.6 | 6.93 | 170 | 258 |
| 6 | 35 | " | 15 | 603 | 52.8 | 7.6 | 6.95 | 192 | 231 |
| 7 | 15 | " | 11 | 320 | 50.8 | 5.1 | 9.96 | 137 | 360 |
| 8 | 15 | " | 20 | 387 | 50.9 | 6.3 | 8.07 | 90 | 311 |
| 9 | 15 | " | 25 | 399 | 51.6 | 7.6 | 6.79 | 82 | 285 |
| 10 | 15 | " | 30 | 430 | 52.0 | 8.6 | 6.05 | 69 | 258 |
| Comparative Example 1 | 10 | Mg | 10 | 270 | 47.3 | 5.6 | 3.92 | 223 | 223 |
| 2 | 0 | " | 5 | 201 | 32.2 | 8.8 | 3.66 | 306 | 480 |
| 3 | 40 | " | 30 | 1021 | 42.2 | 14.0 | 3.01 | 103 | 123 |
| 4 | 35 | Zn | 40 | 998 | 37.7 | 13.7 | 2.75 | 111 | 110 |
| 5 | 40 | Mg | 30 | 2900 | — | — | — | — | 80 |
| 6 | $Pb(Ti_{0.53}Zr_{0.47})O_3$+1.0 mol% $MnO_2$ | | | 1500 | 65 | 33,0 | 1.97 | 1010 | 325 |
| 7 | $(Pb_{0.975}La_{0.025}TiO_3$+1.0 mol% $MnO_2$ | | | 190 | 45 | 7.5 | 8.0 | 1050 | 470 |

1) Medical ultrasonic diagnosis systems:

Conventional PZT-type materials and composite ternary system materials imposed some limitations to the structures of vibrators due to spurious vibrations by transverse waves because they had large transverse coupling factors $K_{31}$. The material used according to this invention has a $K_{31}$ value smaller than those of conventional PZT-type materials and is thus less susceptible of developing spurious vibrations due to transverse waves.

Furthermore, the material used according to this invention has a small Qm value, whereby allowing each pulse to attenuate promptly, in other words, making the breaking time of each pulse shorter and allowing transmission and reception of short pulses. Since the dielectric constant of the material of this invention is relatively large, i.e., ranges from 300 to 1200, it is rather easier to achieve the impedance matching between a pulser drive circuit and its corresponding probe.

2) Ultrasonic metal flaw detecting apparatus:

More conventional X-ray flaw detecting apparatus have recently been replaced by ultrasonic flaw detecting apparatus which uses ultrasonic waves to locate weld flaws, voids, etc. in metals in the non-destructive fashion. PZT-type materials have heretofore been used as materials for their probes. Since they had large transverse $K_{31}$ values, they were unable to obtain waveforms of correct modes by reflected ultrasonic waves.

The material used according to this invention has a small $K_{31}$ value and is thus advantageous for use in such an application.

3) Hydrophones and sonars:

The material used according to this invention is also suitable for vibrators used in the devices such as hydrophones and sonars. This is particularly because it has smaller transverse effect $d_{31}$. The hydrostatic piezoelectric coefficient $d_h$ and the voltage coefficient $g_h$ which represent figures of merits of the hydrophones can be calculated by the following equations:

$$d_h \gtrsim = d_{33} + 2d_{31} \quad (1)$$

$$g_h = d_h/\varepsilon \quad (2)$$

In the conventional PZT-type material, the value of $d_h g_h$ becomes smaller because the symbol of $d_{31}$ is negative and therefore the sum of the doubled $d_{31}$ and the $d_{33}$ is small with the result that $d_h$ is 30 to 50 ($\times 10^{-12}$ C/N), and further because the specific dielectric constant is so large as to make the value of $g_h$ too small. On the other hand, in the material used according to this invention which has large $d_{33}$ and very small $d_{31}$, the value of $d_h$ becomes larger and therefore the material is suitable for the material to be used for the hydrophones, etc.

Moreover, the material used according to this invention has mechanical strength which is approximately twice larger than the conventional PZT material. Accordingly, it shows good performance even when the hydrophones or sonars are operated at a high power.

As has been described above, it is readily appreciated that the piezoelectric ceramic material used according to this invention permits to expand the application field to fields where use of conventional piezoelectric ceramic materials encountered one or more problems.

## Claims

1. Use of a piezoelectric oxide material comprising a composition represented by the general formula:

$$(Pb_{1-a}Ca_a)[(Zn_{1/3}Nb_{2/3})_xTi_{1-x}]O_3$$

wherein $0.10 < x \leqq 0.30$, and $0.10 < a \leqq 0.35$, and having the mechanical quality factor (Qm) of 200 or smaller, the dielectric constant of 300 or greater, the $K_{33}$ value of 50% or greater and the $K_{33}/K_{31}$ ratio of 5 or greater for an ultrasonic probe for medical use including a probe of a medical ultrasonic diagnosis system and a probe of an ultrasonic metal flaw detecting apparatus, and a vibrator of a hydrophone or a sonar.

2. Use according to claim 1, wherein $0.15 \leqq x \leqq 0.25$, and $0.20 \leqq a \leqq 0.30$.

3. Use according to claim 1, wherein $0.15 \leqq x \leqq 0.30$ and $0.20 \leqq a \leqq 0.30$.

## Patentansprüche

1. Verwendung eines piezoelektrischen Oxidmaterials aus einer Zusammensetzung der allgemeinen Formel:

$$(Pb_{1-a}Ca_a)[(Zn_{1/3}Nb_{2/3})_xTi_{1-x})]O_3$$

worin $0{,}10 < x \leqq 0{,}30$, und $0{,}10 < a \leqq 0{,}35$ ist, und mit einem mechanischen Qualitätsfaktor (Qm) von 200 oder

weniger, eine Dielektrizitätskonstante von 300 oder größer, einem $K_{33}$—Wert von 50% oder größer und einem $K_{33}/K_{31}$-Verhältnis von 5 oder größer für eine Ultraschallsonde für medizinische Anwendung, einschließlich einer Sonde für ein medizinisches Ultraschall-Diagnosesystem, und für eine Sonde für eine Ultraschallvorrichtung zum Nachweis von Metalldefekten, und für einen Vibrator für ein Hydrophone oder einen Sonar.

2. Verwendung gemäß Anspruch 1, worin $0,15 \leqq x \leqq 0,25$ und $0,20 \leqq a \leqq 0,30$ ist.

3. Verwendung gemäß Anspruch 1, worin $0,15 \leqq x \leqq 0,30$ und $0,20 \leqq a \leqq 0,30$ ist.

**Revendications**

1. Utilisation d'un matériau oxyde piézoélectrique comprenant une composition représentée par la formule générale:

$$(Pb_{1-a}Ca_a)(Zn_{1/3}Nb_{2/3})xTi_{1-x}\ O_3$$

dans laquelle $0,10 < x \leqq 0,30$, et $0,10 < a \leqq 0,35$, et présentant un facteur de qualité mécanique (Qm) égal ou inférieur à 200, une constante diélectrique égale ou supérieure à 300, une valeur de $R_{33}$ égale ou supérieure à 50%, et un rapport $K_{33}/K_{31}$ égal ou supérieur à 5, pour une sonde à ultrasons pour usage médical, y compris une sonde d'un système de diagnostic médical par ultrasons et une sonde d'un appareil de détection par ultrasons de fissure dans les métaux, ainsi qu'un vibrateur d'un hydrophone ou d'un sonar.

2. Utilisation conforme à la revendication 1, dans laquelle $0,15 \leqq x \leqq 0,25$ et $0,20 \leqq a \leqq 0,30$.

3. Utilisation conforme à la revendication 1, dans laquelle $0,15 \leqq x \leqq 0,30$ et $0,20 \leqq a \leqq 0,30$.

FIG.1

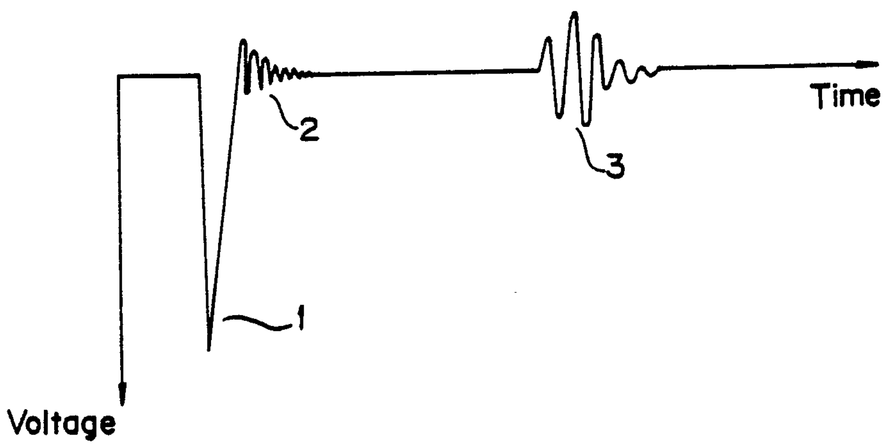


FIG.2

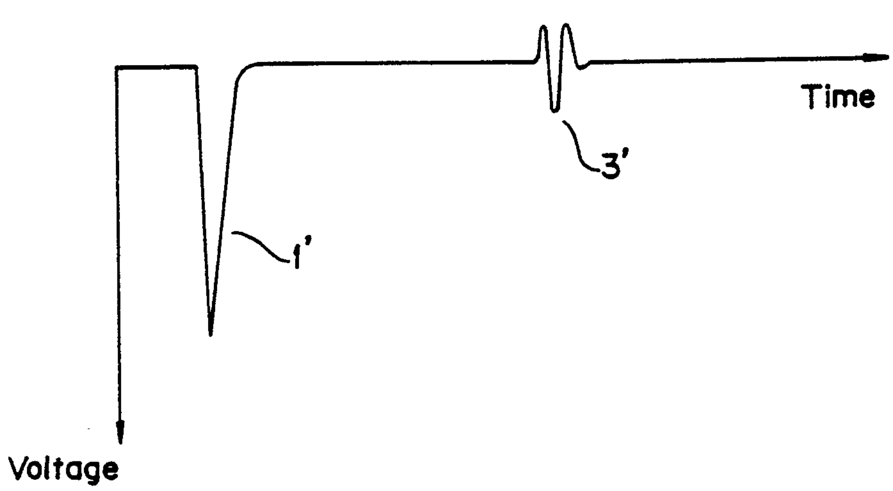

FIG.3

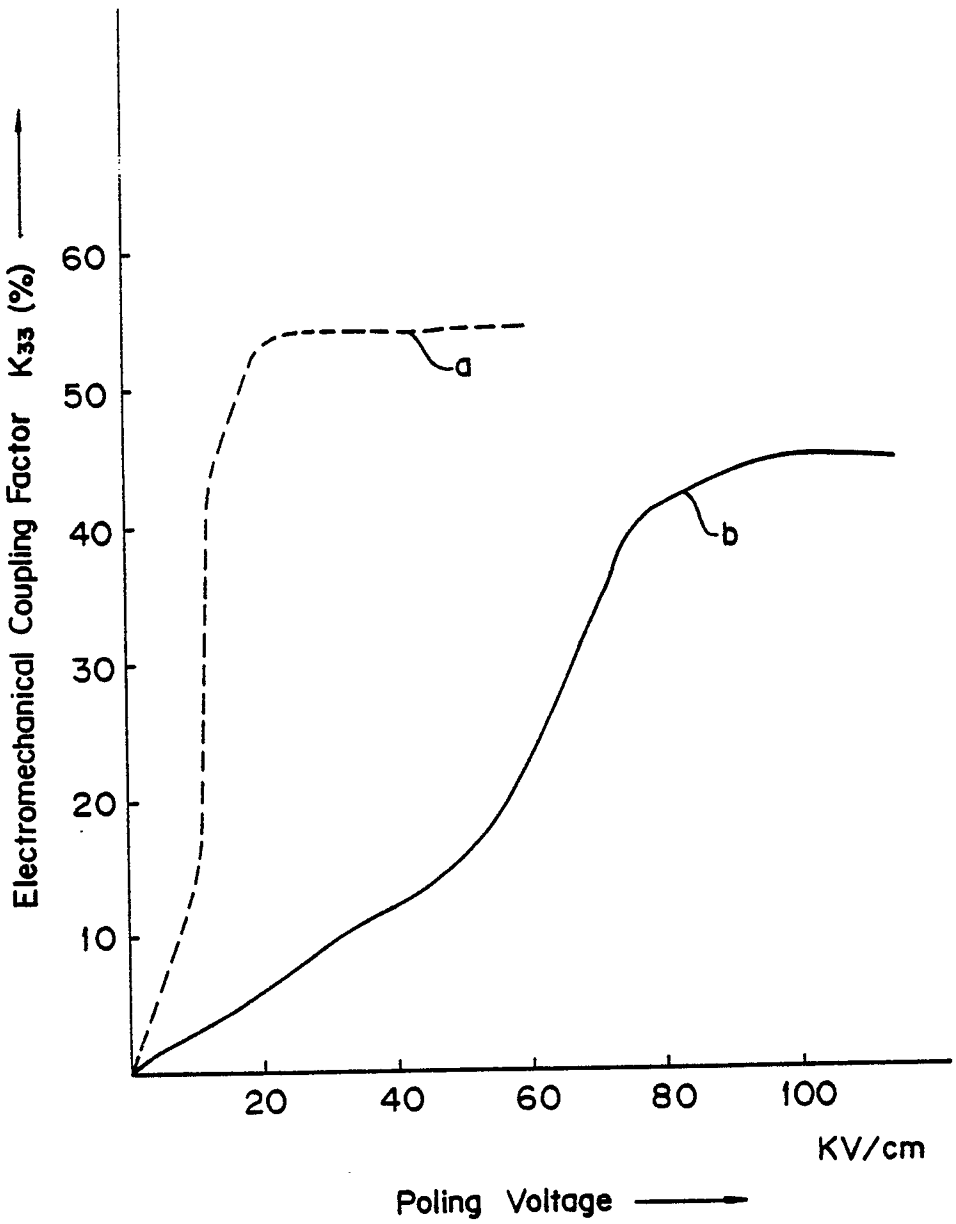
Electromechanical Coupling Factor K33 (%)
60
50
40
30
20
10
a
b
20
40
60
80
100
KV/cm
Poling Voltage